(19) Europäisches Patentamt
European Patent Office
Office européen des brevets

(11) **EP 3 018 697 B1**

(12) **FASCICULE DE BREVET EUROPEEN**

(45) Date de publication et mention
de la délivrance du brevet:
**11.05.2022   Bulletin 2022/19**

(21) Numéro de dépôt: **15193300.9**

(22) Date de dépôt: **05.11.2015**

(51) Classification Internationale des Brevets (IPC):
**H01L 21/20** $^{(2006.01)}$   **H01L 21/02** $^{(2006.01)}$
**C30B 25/16** $^{(2006.01)}$   **C30B 29/08** $^{(2006.01)}$
**C30B 29/42** $^{(2006.01)}$

(52) Classification Coopérative des Brevets (CPC):
**C30B 25/16; C30B 29/08; C30B 29/42;**
**H01L 21/02381; H01L 21/02433; H01L 21/0245;**
**H01L 21/02461; H01L 21/02463; H01L 21/02505;**
**H01L 21/02543; H01L 21/02546; H01L 21/0262**

(54) **PROCÉDÉ DE DÉTERMINATION DE PARAMÈTRES DE DÉPÔT PRÉFÉRENTIELS POUR UNE COUCHE MINCE EN MATÉRIAU III-V**

VERFAHREN ZUR BESTIMMUNG DER GEWÜNSCHTEN AUFBRINGUNGSPARAMETER FÜR EINE DÜNNSCHICHT AUS III-V-HALBLEITERMATERIAL

METHOD FOR DETERMINING PREFERENTIAL DEPOSITION PARAMETERS FOR A THIN FILM OF III-V MATERIAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **05.11.2014   FR 1460693**

(43) Date de publication de la demande:
**11.05.2016   Bulletin 2016/19**

(73) Titulaire: **Commissariat à l'Energie Atomique et aux Energies Alternatives**
**75015 Paris (FR)**

(72) Inventeurs:
• **Bogumilowicz, Yann**
  **38100 Grenoble (FR)**
• **Hartmann, Jean-Michel**
  **38330 Montbonnot Saint-Martin (FR)**

(74) Mandataire: **Talbot, Alexandre et al**
**Cabinet Hecké**
**28 Cours Jean Jaurès**
**38000 Grenoble (FR)**

(56) Documents cités:
**WO-A1-2005/108654**

• **XULIANG ZHOU ET AL: "Epitaxy of GaAs thin film with low defect density and smooth surface on Si substrate", JOURNAL OF SEMICONDUCTORS, vol. 35, no. 7, juillet 2014 (2014-07), page 073002, XP055195579, ISSN: 1674-4926, DOI: 10.1088/1674-4926/35/7/073002**
• **NGOC DUY NGUYEN ET AL: "(Invited) Selective Epitaxial Growth of III-V Semiconductor Heterostructures on Si Substrates for Logic Applications", ESC TRANSACTIONS, vol. 33, no. 6, janvier 2010 (2010-01), pages 933-939, XP055195351, ISSN: 1938-5862, DOI: 10.1149/1.3487625**
• **M. J. LUDOWISE: "Metalorganic chemical vapor deposition of III-V semiconductors", JOURNAL OF APPLIED PHYSICS, vol. 58, no. 8, janvier 1985 (1985-01), page R31, XP055195584, ISSN: 0021-8979, DOI: 10.1063/1.336296**
• **Robert L Mason ET AL: "Statistical Principles in Experimental Design", P A R T II Design and Analysis with Factorial Structure Statistical Design and Analysis of Experiments: With Applications to Engineering and Science, Second Edition, janvier 2003 (2003-01), pages 109-139, XP055195380, Extrait de l'Internet: URL:http://onlinelibrary.wiley.com/store/1 0.1002/0471458503.ch4/asset/ch4.pdf?v=1&t= iata1m3p&s=61fc0814621443d4c3f57025a06ad0 a ea1ded128 [extrait le 2015-06-12]**

- **WANG G ET AL: "Fabrication of high quality Ge virtual substrates by selective epitaxial growth in shallow trench isolated Si (001) trenches", THIN SOLID FILMS, ELSEVIER-SEQUOIA S.A. LAUSANNE, CH, vol. 518, no. 9, 26 février 2010 (2010-02-26), pages 2538-2541, XP026903564, ISSN: 0040-6090, DOI: 10.1016/J.TSF.2009.09.133 [extrait le 2009-10-13]**
- **YU B BOLKHOVITYANOV: "GaAs epitaxy on Si substrates: modern status of research and engineering", PHYSICS - USPEKHI, vol. 51, no. 5, janvier 2008 (2008-01), pages 437-456, XP055029663, DOI: 10.1070/PU2008v051n05ABEH006529**
- **Anthony Jones ET AL: "Chapter 1. Overview of Chemical Vapour Deposition : Precursors, Processes and Applications" In: "Chemical Vapour Deposition: Precursors, Processes and Applications, CHAPTER 1", 1 January 2008 (2008-01-01), ROYAL SOCIETY OF CHEMISTRY, XP055472182, ISBN: 978-0-85404-465-8 pages 1-36, DOI: 10.1039/9781847558794-00001,**
- **TSAUR B-Y ET AL: "HETEROEPITAXY OF VACUUM-EVAPORATED GE FILMS ON SINGLE-CRYSTAL SI", APPLIED PHYSICS LETTERS, A I P PUBLISHING LLC, US, vol. 38, no. 10, 1 May 1981 (1981-05-01), pages 779-781, XP000816717, ISSN: 0003-6951, DOI: 10.1063/1.92160**

## Description

## Domaine de l'invention

L'invention est relative à un procédé de détermination des paramètres de dépôt d'une couche en matériau semi-conducteur de type III-V sur une couche en germanium.

## Etat de la technique

Depuis de nombreuses années, les matériaux semi-conducteurs de type III-V tels que GaAs, InP et leurs alliages associés ont permis un essor considérable de l'opto-électronique. Ces matériaux ont permis la réalisation de dispositifs très performants dans le domaine des diodes lasers et des diodes électroluminescentes.

Cependant, l'utilisation courante des matériaux semi-conducteurs de type III-V est limitée par les difficultés d'intégration de ces matériaux dans les circuits microélectroniques modernes qui sont majoritairement réalisés sur des substrats en silicium. La très grande différence de paramètre de maille qui existe entre les matériaux semi-conducteurs de type III-V et le silicium rend extrêmement difficile l'intégration d'un module opto-électronique sur un substrat en silicium.

L'hétéroépitaxie de couches de GaAs sur des substrats en silicium a fait l'objet de nombreuses recherches depuis plusieurs années. La publication de Kawabe et al. « Molecular Beam Epitaxy of Controlled Single Domain GaAs On Si (100) », Japanese Journal of Applied Physics, Part 2 : Letters, 25(4), pp. 285-287 (1986) décrit la croissance épitaxiale d'une couche de GaAs directement sur un substrat en silicium. La croissance est réalisée par la technique de l'épitaxie par jets moléculaires. Ce document enseigne que l'utilisation d'une surface de silicium désorientée selon l'axe <110> permet de supprimer les parois d'antiphases (désorientation de 4°+/- 1°). Cependant, les substrats de silicium désorientés de quelques degrés sont difficilement compatibles avec l'industrie de la microélectronique. Il est donc très difficile d'utiliser cet enseignement pour la fabrication industrielle de circuits intégrés associés à des modules opto-électroniques à base de matériau semi-conducteur de type III-V.

La publication de Sieg et al. « Anti-Phase Domain-Free Growth of GaAs on Offcut (001) Ge wafers by Molecular Beam Epitaxy with Suppressed Ge Outdiffusion », Journal of Electronics Materials 27(7), pp. 900-907 (1998) décrit la croissance épitaxiale d'une couche de GaAs directement sur un substrat en germanium. Le paramètre de maille du germanium est assez proche du paramètre de maille du cristal de GaAs. Ce document enseigne que l'utilisation d'une surface de germanium de type (001) et désorientée dans la direction <110> permet d'éliminer les parois d'anti-phase. Là encore, il est important de constater que les substrats de germanium sont difficilement utilisables pour former des circuits intégrés.

La publication de Chriqui « Direct Growth of GaAs-based structures on exactly (001)-oriented Ge/Si virtual substrates : reduction of the structural defect density and observation of electroluminescence at room temperature under CW electrical injection », Journal of Crystal Growth 265, pp 53-59 (2004) décrit la croissance d'une couche en GaAs sur une couche en germanium elle-même formée sur un substrat en silicium. La croissance est réalisée par épitaxie en phase vapeur grâce à des précurseurs organométalliques. Différents échantillons sont réalisés et étudiés. Ce document décrit un échantillon dans lequel une couche tampon de GaAs est recouverte par une autre couche de GaAs. Dans une première condition, la croissance de la couche de GaAs est réalisée à une température égale à 650°C. La présence de trous dans les couches de GaAs est constatée. Une croissance à 450°C est également réalisé et la couche formée ne présente plus de trous.

La publication de Xuliang Zhou et al (journal of Semiconductors, vol. 35, n°7, page 073002 juillet 2014) traite de l'épitaxie de GaAs avec une faible densité de défauts et une surface lisse sur un substrat en silicium propose d'optimiser la croissance de films minces de GaAs sur des couches de Ge désalignées. Différentes conditions de dépôt sont présentées pour le dépôt de la couche tampon en germanium ou pour l'épaisseur déposée de film de GaAs. Le substrat utilisé est un substrat de type (100) désaligné de 5° par rapport à la direction [110]. Différentes couches de nucléation sont déposées entre 360°C et 380°C dans la gamme 1,5nm et 4,5nm pour déterminer un couche de nucléation optimale déposée à 360°C.

La publication de Ngoc Duy Nguyen (ECS Transactions, vol. 33, n°6, pages 933-939 janvier 2010) traite de l'épitaxie sélective de GaAs ou de InP sur une couche de Ge. Une couche de $1\mu m$ de Ge est déposée sur une couche de silicium. La couche de Ge est polie par CMP avant le dépôt d'une couche de GaAs ou InP. Le substrat utilisé est un substrat de type (100) désaligné de 6° par rapport à la direction <110>. Une couche de nucléation en InP est déposée à 420°C après un recuit sous AsH3. Le dépôt de la couche de nucléation à 420°C est préférable au dépôt à 400°C.

Le document WO 2005/108654 décrit un procédé de réalisation d'un substrat virtuel pour l'intégration de matériaux III/V sur du Silicium. Le substrat en silicium est surmonté successivement par une couche de Germanium puis par deux couches de GaAs. Le substrat utilisé est un substrat de type (100) désaligné de 6° par rapport à la direction <110>. La première couche en GaAs est déposée à plus basse température que la deuxième couche en GaAs qui la surmonte. La première couche en GaAs est avantageusement déposée en dessous de 500°C par épitaxie par jets moléculaires ou par épitaxie par couches atomiques. La deuxième couche est déposée par épitaxie par jets moléculaire ou par dépôt chimique en phase vapeur aux organométalliques.

La publication de Yu Bolkhovityanov traite de l'épitaxie de GaAs sur une couche en germanium elle-même formée sur un substrat en silicium.

La publication de B Y Tsaur traite de l'épitaxie d'une structure n+/p/p+ GaAs sur une couche en germanium elle-même formée sur un substrat en silicium. Le substrat utilisé est un substrat de type (100) ou (111), la surface présentant une désorientation inférieure à 1°. L'épitaxie est réalisée par épitaxie en phase vapeur (CVD).

**Objet de l'invention**

L'invention a pour objet de présenter un procédé de détermination des conditions de dépôt d'une première couche en matériau semi-conducteur de type III-V sur une couche de germanium qui soit facile à mettre en oeuvre et qui permette de définir rapidement les conditions assurant un dépôt de bonne qualité cristallographique.

On tend à atteindre ce résultat au moyen d'un procédé de détermination de paramètres de dépôt d'une première couche en matériau semi-conducteur de type III-V selon le procédé de la revendication 1.

Dans une variante de réalisation, le procédé comporte en outre :

- réaliser une troisième série d'échantillons dans laquelle la première couche en matériau semi-conducteur de type III-V est recouverte par la deuxième couche en matériau semi-conducteur de type III-V, l'épaisseur de l'empilement formé par les première et deuxième couche étant égale à l'épaisseur E, les conditions de dépôt de la première couche en matériau semi-conducteur de type III-V étant choisies de sorte que l'épaisseur déposée diffère entre les échantillons, la pression de dépôt étant identique entre les échantillons et égale à la première pression de dépôt, la température de dépôt étant égale entre les échantillons et égale à la deuxième température de dépôt,

- déterminer une troisième épaisseur de dépôt de la première couche en matériau semi-conducteur de type III-V à partir de la troisième série d'échantillons au moyen d'un troisième paramètre représentatif de la qualité cristalline de l'empilement formé par les première et deuxième couches en matériau semi-conducteur de type III-V.

Dans un mode de réalisation préférentiel, la deuxième couche de matériau semi-conducteur de type III-V est déposée à une pression égale à 20Torr et à une température à égale à 615°C.

Il est également intéressant de prévoir que la première épaisseur de première couche de matériau semi-conducteur de type III-V est comprise entre 10nm et 80nm et plus particulièrement entre 15nm et 50nm et encore plus particulièrement entre 20 et 40nm.

Dans un mode particulier de réalisation, il est avantageux de prévoir que la première température de dépôt est comprise entre 400°C et 650°C, préférentiellement entre 495°C et 615°C et encore plus préférentiellement entre 500°C et 550°C et de manière particulièrement intéressante entre 515°C et 540°C.

Pour former la couche de germanium, la couche monocristalline de germanium relaxé est épitaxiée depuis une première surface d'orientation cristalline de type (001) d'une couche monocristalline de silicium, la première surface présentant une désorientation inférieure à 1° par rapport au plan (001). La couche monocristalline de germanium est réalisée au moyen d'un premier dépôt d'une premier couche de germanium à une température inférieure à 500°C suivi d'un deuxième dépôt d'une deuxième couche de germanium à une température supérieure à 500°C.

Le matériau semi-conducteur de type III-V choisi parmi GaAs, InP et les alliages ternaires suivant : AlGaAs, InGaAs avec une concentration en indium inférieure ou égale à 10%.

Pour choisir facilement une pression de dépôt intéressante, il est avantageux de choisir que le premier paramètre est une rupture de pente dans une courbe représentative de la densité de défauts visibles par microscopie optique en fonction de la pression de dépôt.

Pour choisir facilement une température de dépôt intéressante, il est avantageux de choisir que le deuxième paramètre est un extremum dans une courbe représentative de la densité de défauts visibles par microscopie optique en fonction de la température de dépôt.

Pour choisir facilement une épaisseur de dépôt intéressante, il est avantageux de choisir que le troisième paramètre est un extremum dans une courbe représentative de la densité de défauts visibles par microscopie optique en fonction de l'épaisseur de la première couche en matériau semi-conducteur de type III-V

Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :

- les figures 1 et 2 représentent, de manière schématique, en coupe transversale un empilement de couches utilisé pour la fabrication d'un échantillon,
- la figure 3 représente de manière schématique un enchainement d'étapes pour la réalisation d'un échantillon,
- la figure 4 représente de manière schématique un enchainement d'étapes pour la détermination des paramètres de dépôt améliorés.

## Description détaillée

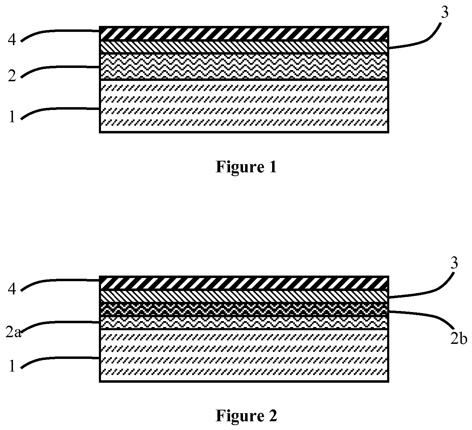

Comme illustré à la figure 1, une couche de silicium 1 recouverte d'une couche de germanium 2 est fournie. La couche de silicium 1 présente une épaisseur avantageusement comprise entre 150μm et 1000μm. La couche de silicium 1 peut former un substrat ou être déposée sur un substrat. Le diamètre du substrat est avantageusement supérieur ou égal à 100mm. Le diamètre du substrat est par exemple égal à 100mm, 200mm ou 300mm de manière à être utilisé par les équipements conventionnels de l'industrie de la microélectronique.

La couche de silicium 1 possède une première face dont l'orientation cristalline est de type (001) de manière à être compatible avec les procédés conventionnels de réalisation des puces microélectronique et plus particulièrement des transistors à effet de champ, par exemple de type MOS. L'orientation cristalline est de type (001), c'est-à-dire que la première face présente une désorientation inférieure à 1° par rapport au plan (001). Le procédé est particulièrement avantageux car il permet de trouver des conditions opératoires optimales pour des substrats de type (001) qui sont faiblement désalignés ou non désalignés ce qui est innovant par rapport aux enseignements de l'art antérieur où les substrats sont fortement désalignés (typiquement plus de 5° de désorientation).

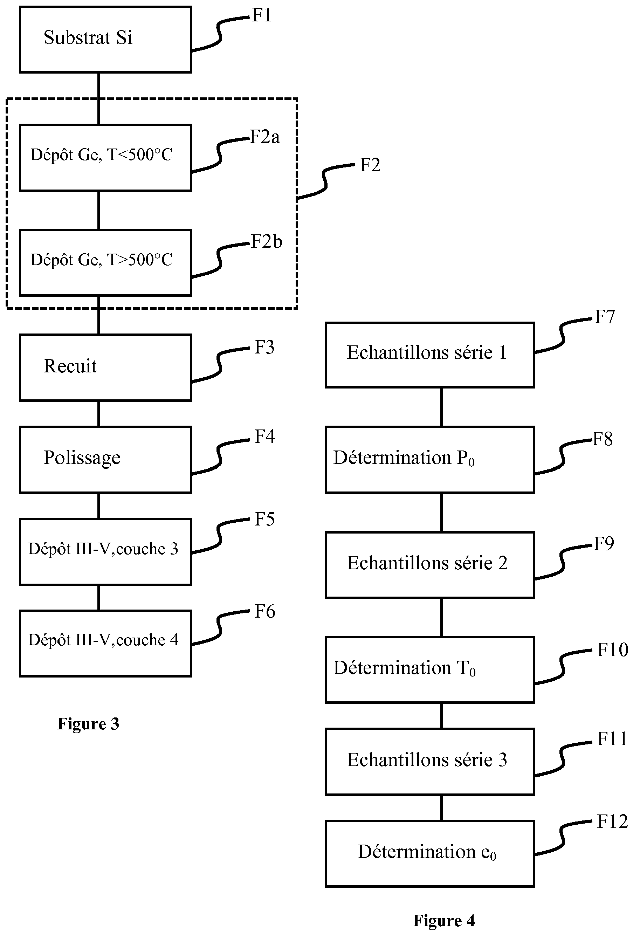

La couche de silicium 1 possède une première face qui est partiellement recouverte ou au moins partiellement recouverte par la couche de germanium Comme illustré à la figure 3, le substrat est réalisé par les étapes suivantes. Un substrat comportant la couche de silicium 1 est fourni dans une étape F1. Une couche de germanium 2 est épitaxiée sur la couche de silicium 1 dans une étape F2.

La couche de germanium 2 est préférentiellement monocristalline. La couche de germanium 2 présente une épaisseur qui est avantageusement comprise entre 0,1μm et 10μm. La couche de germanium 2 est au moins partiellement relaxée de sorte que le paramètre de maille en surface de la couche 2 est égal ou sensiblement égal à celui du cristal de germanium. Par couche de germanium, on entend une ou plusieurs couches de germanium ou d'alliage de silicium-germanium dont la concentration atomique en germanium est au moins égale à 70%. L'ensemble des couches formant la couche de germanium 2 présente une épaisseur totale avantageusement comprise dans la gamme indiquée plus haut. Avantageusement, la partie supérieure de la couche de germanium 2, c'est-à-dire la partie destinée à être en contact avec la couche de matériau semi-conducteur 3 de type III-V est en germanium pur ou en alliage de silicium germanium de sorte que la partie supérieure de la couche de germanium 2 présente le même paramètre de maille que du germanium relaxé. La couche de germanium 2 peut être déposée par tout technique adaptée, par exemple au moyen d'une épitaxie par jets moléculaire ou par dépôt chimique en phase vapeur.

Selon l'invention, illustré à la figure 2, la couche de germanium 2 est réalisée au moyen de deux étapes successives de dépôt d'une couche en germanium, de préférence de germanium pur. Une première étape de dépôt F2a est effectuée avec une température de dépôt inférieure à 500°C pour former une première couche de germanium 2a. Une deuxième étape de dépôt F2b de germanium est ensuite réalisée à une température supérieure à 500°C pour former une deuxième couche de germanium 2b. Ainsi, une première couche de germanium 2a est formée à une température inférieure à 500°C, avantageusement entre 350°C et 450°C, et une deuxième couche de germanium 2b est formée sur la première couche 2a. La deuxième couche de germanium 2b est formée à une température supérieure à 500°C, avantageusement entre 600°C et 750°C. L'utilisation d'une température élevée pour former la deuxième couche de germanium permet de réduire le temps de dépôt lorsque des épaisseurs importantes doivent être déposées.

Cette dissociation en deux étapes de dépôt consécutives F2a et F2b permet d'avoir une surface de meilleure qualité pour la future croissance de la couche 3 de matériau semi-conducteur de type III-V.

Dans le cas d'un dépôt de la couche 1 sur un substrat en silicium, l'utilisation d'une première température de dépôt qui est relativement basse permet d'accommoder le désaccord de paramètre de maille entre le silicium et la couche 2a tout en assurant la formation d'un couche 2a lisse. Ensuite, l'emploi de températures plus élevées pour la croissance de la couche 2b permet de réduire la rugosité de surface et la densité de défauts.

De manière avantageuse, le substrat reste dans la même chambre de dépôt pour la croissance des couches 2a et 2b sans passage dans un environnement extérieur.

Un recuit thermique est réalisé sur l'empilement de la première couche 2a et de la deuxième couche 2b de germanium dans une étape F3. Ce recuit permet réduire les contraintes dans les couches de germanium et de faciliter la relaxation de la couche de germanium. Le recuit est avantageusement réalisé à une température comprise entre 800°C et 900°C, préférentiellement à 850°C. De manière avantageuse, la durée du traitement thermique au-delà de 800°C est de l'ordre de quelques minutes, de préférence entre 1 et 10 minutes. Dans un mode de réalisation particulier, le recuit est réalisé au moyen d'un palier à une température prédéterminée qui représente avantageusement la température maximale du recuit. Dans une variante de réalisation, le recuit est réalisé au moyen de plusieurs températures différentes appliquées consécutivement. Selon l'invention, le recuit comporte une alternance entre une température supérieure et une température inférieure de sorte que le recuit alterne les périodes de montée en température et les périodes de descente en températures. De manière avantageuse, le recuit comporte entre 3 et 4 cycles de température, un cycle comprenant une montée en température et une descente en température. Dans un mode de réalisation avantageux, un cycle comporte également un palier en température dont la durée est préférentiellement entre 1 et 30 secondes. La température supérieure est entre 800°C et 900°C. Dans un mode de réalisation, la température inférieure peut également être comprise entre 800°C et 900°C.

Dans une variante de réalisation qui peut être combinée avec les modes de réalisation précédents, une étape F4 de polissage mécano-chimique est réalisée sur la surface de la couche en germanium 2 ou 2b. De cette manière, il est possible de former une couche de germanium 2/2b dont la surface présente des propriétés similaires à celle d'un substrat en germanium. Cependant, de manière inattendue, il a été observé que de très bons résultats sont obtenus sans utilisation de l'étape de polissage mécano-chimique.

La couche de germanium pur 2 est réalisée au moyen d'un premier dépôt à une température inférieure à 500°C et d'un deuxième dépôt à une température supérieure à 500°C. L'empilement est soumis à un recuit thermique. Avec ces conditions opératoires, il a été possible de réaliser une couche de germanium pur dont le paramètre de maille en surface est identique à celui du cristal de germanium à 0,5% près. Le paramètre de maille mesuré est compris entre 5,63Å et 5,69Å. En surface de la couche de germanium, la rugosité a été mesurée inférieure à 1 nm (rugosité rms pour root-mean-square sur un champ de $1 \times 1 \ \mu m^2$).

Une couche de matériau semi-conducteur de type III-V est ensuite déposée sur la couche de germanium 2 par dépôt chimique en phase vapeur aux organométalliques (MOCVD). De manière particulièrement avantageuse, la couche de matériau semi-conducteur de type III-V est décomposée en deux couches élémentaires appelées première couche de matériau semi-conducteur 3 de type III-V et deuxième couche de matériau semi-conducteur 4 de type III-V. Les couches 3 et 4 sont déposées dans deux étapes distinctes F5 et F6 avec des paramètres de dépôt différents, par exemple des pressions de dépôt et/ou des températures de dépôt différentes.

La deuxième couche de matériau semi-conducteur 4 de type III-V est séparée de la couche de germanium 2 par la première couche de matériau semi-conducteur 3 de type III-V comme cela est visible sur les figures 1 et 2.

Par matériau semi-conducteur de type III-V, on entend un matériau tel que GaAs, InP et les alliages ternaires suivant : AlGaAs, InGaAs avec une concentration en indium inférieure ou égale à 10%. De manière générale, le matériau semi-conducteur de type III-V est un matériau qui présente un paramètre de maille dans la gamme 5,39Å - 5,63Å.

La première couche de matériau semi-conducteur 3 de type III-V déposée est assimilée à une couche de nucléation. Ces conditions de dépôt sont choisies de manière à ce que la couche 3 de matériau III-V recouvre au maximum la surface de la couche de germanium 2.

Le dépôt de la première couche 3 est suivi du dépôt de la deuxième couche 4 de matériau semi-conducteur de type III-V. Les conditions opératoires sont différentes et sont choisies de manière à réaliser l'épaississement de la première couche 3. A titre d'exemple, le dépôt de la deuxième couche 4 est réalisé à une pression totale égale à 20Torr. Cette pression de dépôt permet d'avoir un épaississement de bonne qualité à partir de la première couche 3. La pression de 20Torr permet d'assurer une bonne uniformité de dépôt en plus de la croissance d'un matériau de bonne qualité cristallographique.

A titre d'exemple, une deuxième couche 4 en GaAs peut être déposée dans les conditions suivantes par dépôt chimique en phase vapeur aux organométalliques :

Pression : 20Torr ou 2666,45 Pascal (1pascal = 0,0075006Torr)
Température : 615°C
Précurseurs organométalliques : Tributhylarsenic et Tributhylgallium.

En plus de décomposer le dépôt de la couche de matériau semi-conducteur de type III-V en deux phases distinctes de dépôt, il a été découvert que des conditions opératoires particulièrement avantageuses existent pour le dépôt de la première couche 3 de matériau semi-conducteur de type III-V. Il a été également découvert une manière rapide et efficace d'aboutir à ces conditions de dépôt optimales ou quasi optimales.

Dans une étape F7, un premier jeu d'échantillons est réalisé. Pour chacun des échantillons du premier jeu, deux couches successives de matériau semi-conducteur de type III-V sont déposées, les couches 3 et 4. La première couche 3 de matériau semi-conducteur de type III-V est déposée avec des paramètres de dépôt différents de manière à rechercher l'influence de la pression de dépôt sur la qualité cristallographie de l'empilement de matériau semi-conducteur de type III-V formé par les couches 3 et 4. L'épaisseur déposée de la première couche 3 de matériau semi-conducteur de type III-V est constante entre les échantillons du premier jeu. La température de dépôt est constante entre les échantillons du premier jeu et égale à une température initiale de dépôt.

La deuxième couche de matériau semi-conducteur de type III-V est déposée dans des conditions similaires pour tous les échantillons (épaisseur, température, pression).

Une fois la première série d'échantillons réalisée, ces derniers sont analysés de manière à déterminer l'influence de la pression de dépôt sur au moins un des paramètres représentatifs de la qualité cristallographique du dépôt. Dans une étape F8, cette analyse permet de déterminer une première pression de dépôt $P_0$ qui est la pression optimale de dépôt ou une pression proche de la pression optimale de dépôt pour obtenir un dépôt ayant une bonne qualité cristallographique.

Un premier paramètre est utilisé de manière à déterminer la pression $P_0$. Le premier paramètre est représentatif de la qualité cristallographique de l'ensemble formé par les couches 3 et 4. Dans les exemples à suivre, le paramètre utilisé est une densité de défauts observés en vue de dessus au moyen d'un microscope optique en mode Nomarski. De manière préférentielle, le premier paramètre est une rupture de pente ou un mimima dans une courbe représentative de la densité de défauts visibles optiquement en fonction de la pression de dépôt. La rupture de pente peut être une différence d'au moins 10% dans les pentes des segments de préférence au moins 20% ou au moins 30%.

**Echantillon 1**

La première couche 3 de GaAs a été déposée à une pression de 20Torr et avec une température de dépôt égale à 615°C. Les précurseurs organométalliques sont le Tributhylarsenic et le Tributhylgallium. L'épaisseur de la première couche 3 de GaAs est égale à 80nm et elle a été épaissie au moyen de la deuxième couche 4 de GaAs de sorte que l'épaisseur de l'empilement soit égale à 270nm.

Une observation au microscope optique en mode Nomarski a permis d'observer une grande densité de trous rendant la surface de l'échantillon très rugueuse avec un grossissement x50. Dans les échantillons observés, la densité de trous est supérieure à $10^8/cm^2$.

**Echantillon 2**

La première couche 3 de GaAs a été déposée à une pression de 80Torr et avec une température de dépôt égale à 615°C. Les précurseurs organométalliques sont le Tributhylarsenic et le Tributhylgallium. L'épaisseur de la première couche 3 de GaAs est égale à 80nm et elle a été épaissie au moyen de la deuxième couche 4 de GaAs de sorte que l'épaisseur de l'empilement soit égale à 270nm.

Une observation au microscope optique en mode Nomarski (dans les mêmes conditions que précédemment) a permis d'observer une faible densité de trous rendant la surface de l'échantillon plus facilement utilisable que l'exemple 1. Sur les échantillons observés, la densité de trous est égale à $10^7/cm^2$.

**Echantillon 3**

La première couche 3 de GaAs a été déposée à une pression de 450Torr et avec une température de dépôt égale à 615°C. Les précurseurs organométalliques sont le Tributhylarsenic et le Tributhylgallium. L'épaisseur de la première couche 3 de GaAs est égale à 80nm et elle a été épaissie au moyen de la deuxième couche 4 de GaAs de sorte que l'épaisseur de l'empilement soit égale à 270nm.

Une observation au microscope optique en mode Nomarski n'a pas permis d'observer de trous. La surface apparaît très lisse. Cependant, il a été mesuré une importante non uniformité dans l'épaisseur déposée de la première couche de GaAs. Sur les échantillons observés, la densité de trous est égale à $10^7/cm^2$.

La non-uniformité de l'épaisseur de la première couche 3 de GaAs fait que le dépôt à une pression de 450Torr est inutilisable de manière industrielle. En effet, les mesures d'épaisseur réalisées sur la première couche 3 de GaAs montrent qu'au centre du substrat, l'épaisseur déposée est inférieure à 5nm alors qu'à la périphérie du substrat l'épaisseur déposée est sensiblement égale à 45nm.

Dans l'exemple ci-dessus, la mesure de la densité de trous par une observation au microscope optique en mode Nomarski permet de discriminer des dépôts ayant une bonne qualité cristallographique et des dépôts ayant une qualité cristallographique inacceptable. Cependant, il apparaît également dans l'exemple précédent que le seul critère de la densité de trous n'est pas toujours suffisant et qu'il est avantageux de le combiner avec un critère sur l'uniformité du dépôt.

A titre d'exemple, le critère sur la non uniformité NU peut être calculé de la manière suivante :

$$NU = (Emax - Emin)/Emoy$$

Emax représente l'épaisseur maximale mesurée
Emin représente l'épaisseur minimale mesurée
Emoy représente la valeur moyenne des mesures.

De manière avantageuse, 49 mesures uniformément réparties sont réalisées sur le substrat en excluant les 5mm du bord extérieur du substrat.

Si le critère NU a une valeur inférieure à 0,1, le dépôt est considéré comme uniforme.

Dans une étape F9, un deuxième jeu d'échantillons est réalisé de manière à investiguer l'influence de la température de dépôt sur la qualité cristallographique du matériau semi-conducteur de type III-V.

Pour chacun des échantillons du deuxième jeu, deux couches successives de matériau semi-conducteur de type III-V sont déposées. La première couche 3 de matériau semi-conducteur de type III-V est déposée avec des paramètres différents de manière à rechercher l'influence de la température de dépôt sur la qualité cristallographie du matériau semi-conducteur de type III-V. L'épaisseur déposée de la première couche 3 de matériau semi-conducteur de type III-V est constante entre les échantillons du deuxième jeu. La pression de dépôt est constante entre les échantillons du deuxième jeu et est égale à la première pression de dépôt $P_0$ déterminée précédemment.

La deuxième couche 4 de matériau semi-conducteur de type III-V est déposée dans des conditions similaires pour tous les échantillons (épaisseur, température, pression). Les conditions sont avantageusement similaires à celles de la première série d'échantillons.

Une fois la deuxième série d'échantillons réalisée, ces derniers sont analysés de manière à déterminer l'influence de la température de dépôt sur au moins un des paramètres représentatifs de la qualité cristallographique du dépôt. Dans une étape F10, cette analyse permet de déterminer une première température de dépôt $T_0$ qui est la température optimale de dépôt ou une température proche de la température optimale de dépôt à la première pression de dépôt $P_0$. L'analyse est réalisée au moyen d'un deuxième paramètre qui peut être identique ou différent du premier paramètre représentatif de la qualité cristallographique utilisé pour quantifier l'influence de la pression de dépôt.

Il apparaît préjudiciable de réaliser le dépôt de la couche de matériau semi-conducteur III-V et plus particulièrement de GaAs à une température supérieure à 700°C car dans cette gamme de température les précurseurs organométalliques se décomposent en phase gazeuse pour former des sousespèces qui sont très difficilement incorporables dans les couches semiconductrices. Il est donc avantageux de limiter le domaine d'étude à une température maximale de dépôt inférieure à 700°C et préférentiellement à 650°C Il semble également avantageux de limiter le domaine d'étude une température inférieure égale à 400°C pour ne pas aboutir à des procédés trop longs et donc inadaptés à une utilisation industrielle.

Des échantillons sont formés avec des températures de dépôt comprises entre 495°C et 615°C. Il apparaît qu'à partir de 615°C, une diminution de la température de dépôt permet d'améliorer la qualité des couches de GaAs en diminuant la densité de trous observable. Cependant, il a également été observé qu'en dessous de 500°C, la densité de défauts observés dans les couches de GaAs augmente. Pour une première pression de dépôt $P_0$, il existe une température optimale de dépôt qui n'est pas obligatoirement la température minimale accessible par l'équipement de dépôt. Pour plusieurs conditions d'épaisseur, il semble avantageux de limiter le domaine d'étude à la gamme 500-550ᵒC voire à la gamme 515-540°C car le critère de décision est observé dans ces gammes de température. Il est avantageux de choisir la température initiale de dépôt dans l'une des gammes ci-dessus.

Les différents échantillons ont été observés dans les mêmes conditions que précédemment et les densités de défauts suivantes ont été mesurées.

585°C, la densité de défauts est égale à $1.10^7 cm^{-2}$
555°C, la densité de défauts est égale à $1.10^7 cm^{-2}$
525°C, la densité de défauts est égale à $1.10^6 cm^{-2}$
495°C, la densité de défauts est égale à $2.10^6 cm^{-2}$

A titre d'exemple, le deuxième paramètre permettant de déterminer la première température de dépôt est la densité de défauts observés par microscopie optique en mode Nomarski et plus particulièrement le minimum de la courbe représentant la densité de défauts en fonction de la température. Ce deuxième paramètre de discrimination peut être généralisé à d'autres matériaux que GaAs, par exemple à tous les matériaux semi-conducteurs de type III-V.

Ensuite, dans une étape F11, une troisième série d'échantillons est réalisée. Pour chacun des échantillons du troisième jeu, deux couches successives de matériau semi-conducteur de type III-V sont déposées. La première couche 3 de matériau semi-conducteur de type III-V est déposée à la première température de dépôt $T_0$ et à la première pression de dépôt $P_0$. Seule l'épaisseur déposée varie entre les échantillons de manière à rechercher l'influence de l'épaisseur déposée de première couche 3 sur la qualité cristallographie du matériau semi-conducteur de type III-V final. L'épaisseur déposée de l'empilement formé par les première et deuxième couches de matériau semi-conducteur de type III-V est constante entre les échantillons du troisième jeu.

La deuxième couche 4 de matériau semi-conducteur de type III-V est déposée dans des conditions similaires pour tous les échantillons (température et pression), mais avec une épaisseur variable.

Une fois la troisième série d'échantillons réalisée, ces derniers sont analysés de manière à déterminer l'influence de l'épaisseur de la première couche 3 sur au moins un des paramètres représentatifs de la qualité cristallographique du dépôt total. Cette analyse permet de déterminer une troisième épaisseur de dépôt pour la première couche. Cette analyse est réalisée au moyen d'un troisième paramètre qui peut être différent des premier et deuxième paramètres. Il est également envisageable de prévoir que le troisième paramètre est identique au premier et/ou au deuxième paramètres utilisés précédemment.

A titre d'exemple, pour un dépôt de GaAs d'une épaisseur totale de 270nm, le protocole précédemment décrit permet de déterminer rapidement qu'il est préférable de déposer une première couche de GaAs à une pression $P_0$ égale à 80Torr, avec une température $T_0$ égale à 525°C et une épaisseur de première couche 3 comprise entre 20nm et 40nm.

Comme indiqué plus haut, la couche de GaAs est décomposée en une première couche de nucléation et une deuxième couche d'épaississement. Ces deux couches sont réalisées avec des conditions opératoires différentes. La deuxième couche 2b n'est pas avantageuse pour former toute la couche 2 car elle ne permet pas d'obtenir de faibles densités de défauts. Il est donc avantageux de dissocier la couche 2 en une couche 2a suivie d'une couche 2b.

Dans les exemples précédents de réalisation, les précurseurs organométalliques sont le Tributhylarsenic et Tributhylgallium. Cependant, il est également possible d'utiliser d'autres précurseurs organométalliques, par exemple le triéthylgallium ou le triméthygallium. Il est encore possible d'utiliser des précurseurs de type hydrure, par exemple l'arsine (AsH3) pour l'arsenic.

Bien que les exemples précédents présentent le dépôt de GaAs sur une couche de germanium, il est possible d'utiliser ce procédé de réalisation pour le dépôt d'une couche d'InP sur une couche de germanium elle-même formée éventuellement sur un substrat en silicium.

Dans un mode de réalisation avantageux, l'épaisseur de la première couche 3 est fixée à une valeur comprise entre 20nm et 40nm. Dans ce cas de figure, la troisième série d'échantillons n'est pas réalisée ce qui permet de gagner du temps tout en arrivant à un résultat intéressant. Il est néanmoins avantageux de réaliser la troisième série d'échantillons pour obtenir un résultat optimal.

Dans une variante de réalisation non-revendiquée, la deuxième série d'échantillon est réalisée avant la première série d'échantillons afin de fixer la température de dépôt avant de définir la pression de dépôt. Ce mode de réalisation permet également de trouver un point de fonctionnement satisfaisant. Cependant, ce point de fonctionnement est différent du point de fonctionnement décrit précédemment et il apparaît que les vitesses de dépôt obtenues sont plus faibles. Cette variante semble donc moins avantageuse. A titre d'exemple, dans cette variante de réalisation, la température de dépôt optimale a été choisie égale à 375°C. Puis la pression de dépôt a été choisie égale à 450Torr. L'épaisseur optimale de la première couche 3 a été choisie égale à 30nm.

Dans ce mode de réalisation non-revendiqué, on réalise une première série d'échantillons (F7) dans laquelle la première couche en matériau semi-conducteur (3) de type III-V ayant une première épaisseur est recouverte par la deuxième couche en matériau semi-conducteur (4) ayant une deuxième épaisseur. Les conditions de dépôt de la première couche en matériau semi-conducteur (3) de type III-V sont choisies de sorte que la température de dépôt diffère entre les échantillons. La pression de dépôt est identique entre les échantillons et égale à une pression initiale de dépôt.

Ensuite, on déterminer (F8) une première température de dépôt ($T_0$) à partir de la première série d'échantillons et au moyen d'au moins un premier paramètre représentatif de la qualité cristalline de l'empilement formé par les première et deuxième couches en matériau semi-conducteur (3, 4) de type III-V.

On réalise une deuxième série d'échantillons (F9) dans laquelle la première couche en matériau semi-conducteur (3) de type III-V ayant la première épaisseur est recouverte par la deuxième couche en matériau semi-conducteur (4) de type III-V ayant la deuxième épaisseur. Les conditions de dépôt de la première couche en matériau semi-conducteur (3) de type III-V sont choisies de sorte que la pression de dépôt diffère entre les échantillons. La température de dépôt est identique entre les échantillons et égale à la première température de dépôt ($T_0$).

On détermine (F10) une première pression de dépôt ($P_0$) à partir de la deuxième série d'échantillons et au moyen d'un deuxième paramètre représentatif de la qualité cristalline de l'empilement formé par les première et deuxième couches en matériau semi-conducteur (3, 4) de type III-V.

**Revendications**

1. Procédé de détermination de paramètres de dépôt d'une première couche (3) en matériau semi-conducteur de type III-V dans un échantillon comportant successivement :

    ◦ une couche monocristalline de germanium (2) relaxé épitaxiée depuis une première surface d'orientation cristalline de type (001) d'une couche monocristalline de silicium, la première surface présentant une désorientation inférieure à 1° par rapport au plan (001),
    ◦ une première couche monocristalline en matériau semi-conducteur (3) de type III-V formée par dépôt chimique en phase vapeur aux organométalliques, le matériau semi-conducteur de type III-V étant choisi parmi GaAs, InP et les alliages ternaires suivant : AlGaAs, InGaAs avec une concentration en indium inférieure ou égale à 10%. , l'épaisseur de la première couche monocristalline étant comprise entre 10 et 80 nm,
    ◦une deuxième couche monocristalline en matériau semi-conducteur (4) de type III-V formée par dépôt chimique en phase vapeur aux organométalliques, l'empilement formé par les première et deuxième couches en matériau semi-conducteur (3, 4) de type III-V ayant une épaisseur E,

    le procédé comportant :

    - réaliser la couche monocristalline de germanium (2) relaxé par épitaxie par jets moléculaires ou par dépôt chimique en phase vapeur, la couche monocristalline de germanium (2) relaxé étant réalisée au moyen d'un premier dépôt (F2a) d'une premier couche de germanium (2a) à une température inférieure à 500°C suivi d'un deuxième dépôt (F2b) d'une deuxième couche de germanium (2b) à une température supérieure à 500°C,
    - réaliser un recuit thermique sur l'empilement de la première couche (2a) et de la deuxième couche (2b) de germanium au moyen d'une alternance entre une température supérieure et une température inférieure, la température supérieure étant comprise entre 800°C et 900°C,
    - réaliser une première série d'échantillons (F7) dans laquelle la première couche en matériau semi-conducteur (3) de type III-V ayant une première épaisseur est recouverte par la deuxième couche en matériau semi-conducteur (4) ayant une deuxième épaisseur, les conditions de dépôt de la première couche en matériau semi-conducteur (3) de type III-V étant choisies de sorte que la pression de dépôt diffère entre les échantillons, la température de dépôt étant identique entre les échantillons et égale à une température initiale de dépôt, la température initiale de dépôt étant comprise entre 495°C et 615°C,

- déterminer (F8) une première pression de dépôt (Po) à partir de la première série d'échantillons et au moyen d'au moins un premier paramètre représentatif de la qualité cristalline de l'empilement formé par les première et deuxième couches en matériau semi-conducteur (3, 4) de type III-V, le premier paramètre étant une densité de défauts observés en vue de dessus au moyen d'un microscope optique en mode Nomarski,

- réaliser une deuxième série d'échantillons (F9) dans laquelle la première couche en matériau semi-conducteur (3) de type III-V ayant la première épaisseur est recouverte par la deuxième couche en matériau semi-conducteur (4) de type III-V ayant la deuxième épaisseur, les conditions de dépôt de la première couche en matériau semi-conducteur (3) de type III-V étant choisies de sorte que la température de dépôt diffère entre les échantillons, la pression de dépôt étant identique entre les échantillons et égale à la première pression de dépôt (Po),

- déterminer (F10) une première température de dépôt (To) à partir de la deuxième série d'échantillons et au moyen d'un deuxième paramètre représentatif de la qualité cristalline de l'empilement formé par les première et deuxième couches en matériau semi-conducteur (3, 4) de type III-V.

2. Procédé de détermination selon la revendication 1, **caractérisé en ce qu'**il comporte :

- réaliser une troisième série d'échantillons (F11) dans laquelle la première couche en matériau semi-conducteur (3) de type III-V est recouverte par la deuxième couche en matériau semi-conducteur (4) de type III-V, l'épaisseur de l'empilement formé par les première et deuxième couches de matériau semi-conducteur (3, 4) de type III-V étant égale à l'épaisseur E, les conditions de dépôt de la première couche en matériau semi-conducteur (3) de type III-V étant choisies de sorte que l'épaisseur déposée diffère entre les échantillons, la pression de dépôt étant identique entre les échantillons et égale à la première pression de dépôt (Po), la température de dépôt étant égale entre les échantillons et égale à la première température de dépôt (To),

- déterminer (F12) une troisième épaisseur de dépôt de la première couche en matériau semi-conducteur (3) de type III-V à partir de la troisième série d'échantillons au moyen d'un troisième paramètre représentatif de la qualité cristalline de l'empilement formé par les première et deuxième couches en matériau semi-conducteur (3 ,4) de type III-V.

3. Procédé de détermination selon l'une quelconque des revendications 1 et 2, **caractérisé en ce que** la deuxième couche de matériau semi-conducteur (4) de type III-V est déposée à une pression égale à 2666,45 Pascal et à une température à égale à 615°C.

4. Procédé de détermination selon la revendication 3, **caractérisé en ce que** la première épaisseur de première couche de matériau semi-conducteur (3) de type III-V est comprise entre 15nm et 50nm.

5. Procédé de détermination selon la revendication 4, **caractérisé en ce que** la première épaisseur de première couche de matériau semi-conducteur (3) de type III-V est comprise entre 20 et 40nm.

6. Procédé de détermination selon la revendication 1, **caractérisé en ce que** la température initiale de dépôt est comprise entre 500°C et 550°C.

7. Procédé de détermination selon la revendication 6, **caractérisé en ce que** la température initiale de dépôt est comprise entre 515°C et 540°C.

**Patentansprüche**

1. Verfahren zur Bestimmung der gewünschten Abscheidungsparameter einer ersten III-V-Halbleitermaterialschicht (3) in einer Probe, die aufeinanderfolgend umfasst:

∘ eine relaxierte monokristalline Germaniumschicht (2), die auf einer ersten Oberfläche mit einer (001)-Kristallorientierung einer monokristallinen Siliziumschicht epitaktisch aufgebracht ist, wobei die erste Oberfläche zur (001)-Ebene eine Fehlorientierung kleiner als 1° aufweist,
∘ eine erste monokristalline III-V-Halbleitermaterialschicht (3), die durch metallorganische chemische Dampfabscheidung gebildet wird, wobei das III-V-Halbleitermaterial aus GaAs, InP und den folgenden ternären Legierungen gewählt ist: AlGaAs, InGaAs mit einer Indiumkonzentration kleiner oder gleich 10 %, wobei die Dicke der ersten monokristallinen Schicht zwischen 10 und 80 nm liegt,
∘ eine zweite monokristalline III-V-Halbleitermaterialschicht (4), die durch metallorganische chemische Dampfabscheidung gebildet wird, wobei der Stapel, der durch die erste und die zweite III-V-Halbleitermaterialschicht (3, 4) gebildet wird, eine Dicke E aufweist,

wobei das Verfahren umfasst:

- Herstellen der relaxierten monokristallinen Germaniumschicht (2) durch Molekularstrahlepitaxie oder chemische Dampfabscheidung, wobei die relaxierte monokristalline Germaniumschicht (2) hergestellt wird durch eine erste Abscheidung (F2a) einer ersten Germaniumschicht (2a) bei einer Temperatur kleiner als 500 °C, gefolgt von einer zweiten Abscheidung (F2b) einer zweiten Germaniumschicht (2b) bei einer Temperatur größer als 500 °C,
- Durchführen einer Temperung des Stapels aus der ersten Germaniumschicht (2a) und der zweiten Germaniumschicht (2b) durch einen Wechsel zwischen einer höheren und einer niedrigeren Temperatur, wobei die höhere Temperatur zwischen 800 °C und 900 °C liegt,
- Herstellen einer ersten Probenreihe (F7), bei welcher die erste III-V-Halbleitermaterialschicht (3) einer ersten Dicke mit der zweiten Halbleitermaterialschicht (4) einer zweiten Dicke bedeckt ist, wobei die Abscheidungsbedingungen der ersten III-V-Halbleitermaterialschicht (3) so gewählt sind, dass der Abscheidungsdruck zwischen den Proben unterschiedlich ist, die Abscheidungstemperatur zwischen den Proben gleich ist und einer Anfangsabscheidungstemperatur entspricht, wobei die Anfangsabscheidungstemperatur zwischen 495 °C und 615 °C liegt,
- Bestimmen (F8) eines ersten Abscheidungsdrucks (Po) anhand der ersten Probenreihe und unter Verwendung mindestens eines ersten Parameters, der für die Kristallqualität des Stapels, der durch die erste und die zweite III-V-Halbleitermaterialschicht (3, 4) gebildet wird, repräsentativ ist, wobei der erste Parameter eine Fehlerdichte ist, die mit einem Lichtmikroskop im Nomarski-Modus in der Draufsicht zu beobachten ist,
- Herstellen einer zweiten Probenreihe (F9), bei welcher die erste III-V-Halbleitermaterialschicht (3) der ersten Dicke mit der zweiten III-V-Halbleitermaterialschicht (4) der zweiten Dicke bedeckt ist, wobei die Abscheidungsbedingungen der ersten III-V-Halbleitermaterialschicht (3) so gewählt sind, dass die Abscheidungstemperatur zwischen den Proben unterschiedlich ist, wobei der Abscheidungsdruck zwischen den Proben gleich ist und dem ersten Abscheidungsdruck (Po) entspricht,
- Bestimmen (F10) einer ersten Abscheidungstemperatur (To) anhand der zweiten Probenreihe und unter Verwendung eines zweiten Parameters, der für die Kristallqualität des Stapels, der durch die erste und die zweite III-V-Halbleitermaterialschicht (3, 4) gebildet wird, repräsentativ ist.

2. Bestimmungsverfahren nach Anspruch 1, **dadurch gekennzeichnet, dass** es umfasst:

- Herstellen einer dritten Probenreihe (F11), bei welcher die erste III-V-Halbleitermaterialschicht (3) mit der zweiten III-V-Halbleitermaterialschicht (4) bedeckt ist, wobei die Dicke des Stapels, der durch die erste und die zweite III-V-Halbleitermaterialschicht (3, 4) gebildet wird, der Dicke E entspricht, wobei die Abscheidungsbedingungen der ersten III-V-Halbleitermaterialschicht (3) so gewählt sind, dass die abgeschiedene Dicke zwischen den Proben unterschiedlich ist, wobei der Abscheidungsdruck zwischen den Proben gleich ist und dem ersten Abscheidungsdruck (Po) entspricht, wobei die Abscheidungstemperatur zwischen den Proben gleich ist und der ersten Abscheidungstemperatur (To) entspricht,
- Bestimmen (F12) einer dritten Abscheidungsdicke der ersten III-V-Halbleitermaterialschicht (3) anhand der dritten Probenreihe unter Verwendung eines dritten Parameters, der für die Kristallqualität des Stapels, der durch die erste und zweite III-V-Halbleitermaterialschicht (3, 4) gebildet wird, repräsentativ ist.

3. Bestimmungsverfahren nach einem der Ansprüche 1 und 2, **dadurch gekennzeichnet, dass** die zweite III-V-Halbleitermaterialschicht (4) bei einem Druck von 2666,45 Pascal und einer Temperatur von 615 °C abgeschieden wird.

4. Bestimmungsverfahren nach Anspruch 3, **dadurch gekennzeichnet, dass** die erste Dicke der ersten III-V-Halbleitermaterialschicht (3) zwischen 15 nm und 50 nm liegt.

5. Bestimmungsverfahren nach Anspruch 4, **dadurch gekennzeichnet, dass** die erste Dicke der ersten III-V-Halbleitermaterialschicht (3) zwischen 20 und 40 nm liegt.

6. Bestimmungsverfahren nach Anspruch 1, **dadurch gekennzeichnet, dass** die Anfangsabscheidungstemperatur zwischen 500 °C und 550 °C liegt.

7. Bestimmungsverfahren nach Anspruch 6, **dadurch**

**gekennzeichnet, dass** die Anfangsabscheidungstemperatur zwischen 515°C und 540°C liegt.

**Claims**

1. A method for determining deposition parameters of a first layer (3) made from semiconductor material of III-V type in a sample successively comprising:

   ∘ a monocrystalline layer of relaxed germanium epitaxially grown from a first surface of crystalline orientation of (001) type of a monocrystalline silicon layer, the first surface presenting a misalignment of less than 1° with respect to a (001) plane,
   ∘ a first monocrystalline layer made from semiconductor material (3) of III-V type formed by organometallic chemical vapor deposition, the semiconductor material of III-V type being selected from GaAs, InP and the following ternary alloys: AlGaAs, InGaAs with an indium concentration lower than or equal to 10%, the thickness of the first monocrystalline layer being between 10 and 80nm,
   ∘ a second monocrystalline layer made from semiconductor material (4) of III-V type formed by organometallic chemical vapor deposition, the stack formed by the first and second layers made from semiconductor material of III-V type having a thickness E,

   the method comprising:

   - producing the monocrystalline layer of relaxed germanium (2) by molecular beam epitaxy or by chemical vapor deposition, the monocrystalline layer of relaxed germanium (2) being produced means of a first deposition (F2a) of a first germanium layer (2a) at a temperature of less than 500°C followed by a second deposition (F2b) of a second germanium layer (2b) at a temperature of more than 500°C,
   - performing a thermal annealing on the stack of the first germanium layer (2a) and the second germanium layer (2b) by alternating between a higher temperature and a lower temperature, the higher temperature being between 800°C and 900°C
   - making a first series of samples (F7) in which the first layer made from semiconductor material (3) of III-V type having a first thickness is covered by the second layer made from semiconductor material (4) having a second thickness, the deposition conditions of the first layer made from semiconductor material (3) of III-V type being chosen such that the deposition pressure differs between the samples, the deposition temperature being identical between the samples and equal to an initial deposition temperature, the initial deposition temperature being comprised between 495°C and 615°C,
   - determining (F8) a first deposition pressure (Po) from the first series of samples and by means of at least a first parameter representative of a crystalline quality of the stack formed by the first and second monocrystalline layers of semiconductor material of III-V type, the first parameter being a density of defects observed in top view by means of an optical microscope in Nomarski mode,
   - making a second series of samples (F9) in which the first layer made from semiconductor material (3) of III-V type having the first thickness is covered by the second layer made from semiconductor material (4) of III-V type having the second thickness, the deposition conditions of the first layer made from semiconductor material (3) of III-V type being chosen such that the deposition temperature differs between the samples, the deposition pressure being identical between the samples of the second series and equal to the first deposition pressure (Po),
   - determining (F10) a first deposition temperature (To) from the second series of samples and by means of a second parameter representative of the crystalline quality of the stack formed by the first and second monocrystalline layers (3, 4) made from semiconductor material of III-V type.

2. The method for determining according to claim 1, **characterized in that** it comprises:

   - making a third series of samples (F11) in which the first layer of semiconductor material (3) of III-V type is covered by the second layer of semiconductor material (4) of III-V type, the thickness of the stack formed by the first and second layers made from (3,4) semiconductor material of III-V type being equal to the thickness E, the deposition conditions of the first layer made from semiconductor material of III-V type being chosen such that the deposited thickness differs between the samples, the deposition pressure being identical between the samples and equal to the first deposition pressure (Po), the deposition temperature being equal between the samples and equal to the first deposition temperature, (To)
   - determining (F12) a third deposition thickness of the first layer made from semiconductor material (3) of III-V type from the third series of samples by means of a third parameter representative of the crystalline quality of the stack formed by the first and second monocrystalline layers made from semiconductor material (3, 4) of III-V type.

3. The method for determining according to anyone of claims 1 and 2, **characterized in that** the second layer made from semiconductor material (4) of III-V type is deposited at a pressure equal to 2666,45 Pascal and at a temperature equal to 615°C.

4. The method for determining according to claim 3, **characterized in that** the first thickness of the first layer made from semiconductor material (3) of III-V type is comprised between 15nm and 50nm.

5. The method for determining according to claim 4, **characterized in that** the first thickness of the first layer made from semiconductor material of III-V type is comprised between 20nm and 40nm.

6. The method for determining according to claim 1, **characterized in that** the initial deposition temperature is comprised between 500°C and 550°C.

7. The method for determining according to claim 6, **characterized in that** the initial deposition temperature is comprised between 515°C and 540°C.

**Figure 1**

**Figure 2**

Substrat Si — F1

Dépôt Ge, T<500°C — F2a

Dépôt Ge, T>500°C — F2b

F2

Recuit — F3

Polissage — F4

Dépôt III-V, couche 3 — F5

Dépôt III-V, couche 4 — F6

**Figure 3**

Echantillons série 1 — F7

Détermination $P_0$ — F8

Echantillons série 2 — F9

Détermination $T_0$ — F10

Echantillons série 3 — F11

Détermination $e_0$ — F12

**Figure 4**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2005108654 A

**Littérature non-brevet citée dans la description**

- **KAWABE et al.** Molecular Beam Epitaxy of Controlled Single Domain GaAs On Si (100). *Japanese Journal of Applied Physics, Part 2 : Letters,* 1986, vol. 25 (4), 285-287
- **SIEG et al.** Anti-Phase Domain-Free Growth of GaAs on Offcut (001) Ge wafers by Molecular Beam Epitaxy with Suppressed Ge Outdiffusion. *Journal of Electronics Materials,* 1998, vol. 27 (7), 900-907

- **CHRIQUI.** Direct Growth of GaAs-based structures on exactly (001)-oriented Ge/Si virtual substrates : reduction of the structural defect density and observation of electroluminescence at room temperature under CW electrical injection. *Journal of Crystal Growth,* 2004, vol. 265, 53-59
- **XULIANG ZHOU et al.** *journal of Semiconductors,* Juillet 2014, vol. 35 (7), 073002
- **NGOC DUY NGUYEN.** *ECS Transactions,* Janvier 2010, vol. 33 (6), 933-939